(19) Europäisches Patentamt
European Patent Office
Office européen des brevets

(11) **EP 3 462 462 A1**

(12) **EUROPEAN PATENT APPLICATION**

(43) Date of publication:
**03.04.2019 Bulletin 2019/14**

(51) Int Cl.:
**H01B 1/02** (2006.01)   **C22C 1/00** (2006.01)
**H05K 1/02** (2006.01)

(21) Application number: **18195348.0**

(22) Date of filing: **19.09.2018**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **28.09.2017 EP 17193876**

(71) Applicant: **Ecole Polytechnique Federale De
Lausanne
(EPFL) EPFL-TTO
1015 Lausanne (CH)**

(72) Inventors:
• HIRSCH, Arthur
  **1005 Lausanne (CH)**
• LACOUR, Stephanie P.
  **1163 Etoy (CH)**

(74) Representative: **Zardi, Marco
M. Zardi & Co. SA
Via Pioda 6
6900 Lugano (CH)**

(54) **PATTERNED BIPHASIC ELECTRICAL CONDUCTOR AND METHODS FOR PRODUCING THEREOF**

(57) A method for manufacturing an electrical conductor is herein disclosed, said method comprising a) providing a substrate comprising on a surface thereof a solid metal conductive layer or film; b) depositing a liquid metal on said solid layer; c) allowing said liquid metal and said solid layer to alloy by diffusion of said liquid metal into said solid layer or film so as to form a solid conductive layer or film of said alloy; and d) allowing said liquid metal to further depose onto said alloy layer so as to form a biphasic conductive layer comprising said solid alloy as a solid phase and said liquid metal as a liquid phase deposed thereon, characterized in that said surface of said substrate comprises a plurality of protrusions being separated by grooves. An electrical conductor manufactured by performing a method according to invention is also herein disclosed.

Figure 1

**Description**

Technical Field

The present invention belongs to the field of electrical conductors. In particular, the present invention relates to highly conductive electrical conductors such as elastically stretchable electrical conductors.

Background Art

The wetting behaviour of a liquid to a substrate or film in general, depends both on the chemical affinity of the materials and the surface topology of the substrate and/or film. Water is repelled by substrates and films of hydrophobic materials, beading up to form drops with contact angles larger than 90° ($\Theta_e > 90°$) and spreading out on surfaces of hydrophilic materials to form extended drops with a contact angle smaller than 90° ($\vartheta e < 90°$). When referencing liquids other than water, the general used terms are lyophobic and lyophilic. The wetting properties can be further enhanced by controlling surface roughness of the substrate or film. Engineering a micro-texture on a lyophobic substrate or film increases the contact angle (Lafuma and Quéré 2003; Quéré 2008), and can be leveraged to produce super-hydrophobic surfaces ($\vartheta e > 150°$) for applications such as self-cleaning surfaces. Similarly, increasing the roughness of a lyophilic substrate or film reduces the effective contact angle and even leads to the formation of a continuous liquid film through imbibition of the surface roughness (Courbin et al., Nature Materials 2007, 6, 661 - 664).

Gallium is a unique metallic liquid. With a melting point of 30°C and the ability to supercool, it can be handled in the liquid state at room temperature. Unlike mercury, it has a near zero vapour pressure and low toxicity, making it safe to manipulate. Gallium and some gallium based alloys have recently gathered a significant interest among the scientific community as they offer a unique set of properties for the design of soft, stretchable and reconfigurable electronics (Dickey 2017).

The practical implementation of gallium outside of the lab, however, has been hindered or at least rendered difficult by the unique rheology of gallium, making it difficult to process and pattern with conventional techniques (Joshipura et al. 2015). In oxygen free environments, gallium does not wet materials like polymers or glass. The high surface tension of gallium (708 J*m$^{-2}$) (Zhao, Xu, and Liu 2017) prevents the design of freestanding structures below the capillary length ($\approx 4$ mm). In the presence of oxygen, however, gallium spontaneously forms a solid passivation oxide skin ($\approx 3$ nm). The oxide can counterbalance the surface tension and enables the creation of non-spherical metastable shapes at length scales below the capillary length. Accordingly, patterning techniques such as 3D printing, spraying or doctor blading rely on the presence of the oxide to stabilise the liquid metal after forcing it into a prescribed shape.

The primary limitation of these approaches is the absence of fine control on the thickness and roughness. Applications such as stretchable electronics require such control for creating films with well defined and reproducible electrical properties. To address this issue, the present inventors have recently developed an alternative process relying solely on wetting phenomena to deposit and pattern stable thin and uniform films of liquid metal on various substrates. The receiving surface is rendered gallium lyophilic by sputtering a gold thin film (60nm) prior to thermal evaporation of gallium in vacuum (Hirsch et al., Adv. Mater. 2016, 28, 4507 - 4512; WO 2017/072347).

During this vapour phase deposition process, gallium first condenses and alloys with the gold layer to form AuGa2. Once the point of elemental ratio exceeds two, the excess gallium that condenses on the surface accumulates in drops with an averaged contact angle of 23°; drops next grow in size and number as the deposition continues. The resulting inhomogeneous (rough) film consists of most of the liquid material accumulating in drops (>20$\mu$m in diameter) while some of the film remains thin. The film displays good electromechanical behaviour with a low sheet resistance (0.5 $\Omega$/sq.) and large stretchability (400% strain), that are yet limited by the inhomogeneity of the film. Indeed, increasing the amount of gallium deposited does not significantly decreases the sheet resistance below 0.5 $\Omega$/sq. as most of the conductive material accumulates in the drops.

The large surface tension of the Gallium prevents the deposition of a uniform (in thickness) film of liquid gallium; thickness non uniformity results in local concentration of current density in the thin part of the film and higher resistance than in the hypothetic homogenous equivalent film, when used as an electrical conductor. At the same time, an approach as described by Courbin et al. is not suitable for a liquid that is hindered by a solid oxide skin like gallium is in presence of oxygen, since the presence of the oxide on the gallium changes its rheology compared to a liquid such as water.

There is therefore still need of improved metal liquid-based conductors that display for instance a lower sheet resistance and/or a better distribution or uniformity of the current in the conductor, while keeping its stretchable behavior whenever needed.

Summary of invention

Accordingly, the present inventors developed methods and devices that address and overcome the drawbacks of the prior art solutions as summarized above. In particular, the methods according to the present invention have revealed to be particularly suitable and/or convenient for manufacturing conductive stretchable circuits, arrays and/or interconnections in general. However, it has to be noted that the possible applications of the methods and devices according to the present invention are not limited to the manufacturing of stretchable circuits and/or interconnections; to the contrary, the methods according to the present invention are adapted to be carried out for the formation on any substrate of either stretchable or not stretchable circuits, arrays, paths, films or the like and conductors in general.

A first aim of the invention was to upgrade biphasic electrical conductors previously manufactured by the present inventors, as described in WO 2017072347, by minimally drifting from the manufacturing method already set up therein.

Another aim of the invention was to provide electrical conductors with improved properties in term of current distribution and sheet resistance.

Still a further aim of the invention was to provide electrical conductors with improved properties by engineering the topology of a support substrate or film, without altering the chemistry of the elements composing it. All these aims have been accomplished by the present invention as defined in the appended claims. It has been successfully demonstrated by the present inventors that adding a controlled micro-texture topology in addition to the gallium lyophilic coating enables to produce smooth thin films of gallium by imbibition, thus obtaining improved biphasic electrical conductors. The inventors combined engineered micro-structure with the previously described gallium lyophilic coating to produce gallium super-lyophilic substrates. This new approach enables to produce smooth film of gallium on extended areas with tailored thickness and electrical properties. Further, the conditions for the stable growth of the film were derived, and a deterministic relation between the geometrical parameters of the micro-texture and the resulting sheet resistance established. The present disclosure provides design guidelines and open new routes for the fabrication of tailored liquid metal stretchable electronics.

One consideration upon which the invention is based is that a biphasic film cannot be described by a simple plain solid liquid model, i.e. it is not behaving like a liquid wetting a solid when disposed on a support or substrate; a large amount (e.g., a drop) of a liquid material such as a gallium drop on a substrate or film will not fill the roughness of a patterned support by imbibition. However, by exploiting a bottom up manufacturing approach, the inventors proved able to grow a film within a patterned substrate and fill it on all the surface rather than diffuse from a single point. This is mainly possible, by way of example, by techniques such as physical vapour deposition (PVD), which breaks up the bulk gallium in an atomic vapour that condenses on the substrate; in that way, the substrate enables to tailor the growth of the liquid gallium bulges into a controlled film by taking advantage of the topology.

The final result is a biphasic conductor device, possibly soft and even stretchable depending on the needs and/or the circumstances, having a sheet resistance lower compared to a non-textured surface counterpart because of the higher homogeneity of the so-obtained liquid layer. The homogenous film avoids current concentration compared to the one with bulges. Moreover, it has been shown that sheet resistance can be tuned by playing with the geometrical parameters, so that identifying and picking the right geometrical parameters allow to fabricate devices with specific sheet resistances.

Accordingly, one aspect of the invention relates to a method for manufacturing an electrical conductor, said method comprising:

a) providing a solid metal conductive layer or film 600;
b) depositing a liquid metal 400 on said solid layer 600;
c) allowing said liquid metal 400 and said solid layer 600 to alloy by diffusion of said liquid metal 400 into said solid layer or film 600 so as to form a solid conductive layer or film 601 of said alloy; and
d) allowing said liquid metal 400 to further depose onto said alloy layer 601 so as to form a biphasic conductive layer 602 comprising said solid layer or film 601 as a solid phase and said liquid metal 400 as a liquid phase deposed thereon,

characterized in that said surface of said conductive layer or film 600 comprises a plurality of grooves 300, and in that said liquid metal 400 is allowed to further depose onto said solid layer or film 601 so as to at least partially fill said grooves 300.

According to an embodiment said method comprises:

providing a substrate 200;
providing a solid metal conductive layer or film 600 on a surface thereof;
wherein said surface of said substrate 200 comprises said plurality grooves 300, and wherein providing said solid metal conductive layer or film 600 on said surface of said substrate 200 is carried out so that the exposed surface of said conductive layer or film 600 still comprises said plurality of grooves 300.

According to an embodiment said grooves 300 are defined by a plurality of protrusions 200, each protrusion 200 having a height h, a length a and a depth d, said protrusions (200) being separated by said grooves 300.

In one embodiment, the protrusions are obtained by lithography, molding or etching of the substrate or the like.

In one embodiment, the protrusions have a small aspect ratio.

In preferred embodiments, the protrusions are shaped as regular or irregular polyhedral pillars.

In one embodiment, said liquid metal may be deposited on said solid conductive metal layer or film by physical vapour deposition, chemical vapour deposition, spray or condensation or similar methods of said liquid metal.

In one embodiment, said liquid metal may comprise one of Gallium and a Gallium-based alloy.

In one embodiment, said solid metal conductive layer or film may be sputtered on said substrate.

In one embodiment, said solid metal conductive layer or film may be made of one of Au, Pd, Pt, Ir, and an alloy thereof.

In one embodiment, the thickness of said solid metal conductive layer or film is between 1 nm and 1$\mu$m, such as about 50 nm.

In one embodiment, the ratio n between the number of atoms of said liquid metal and the number of atoms of said solid metal layer or film in said biphasic layer or film is $\geq 4$, and preferably between 4 and $10^9$, such as 100 or $10^5$.

In one embodiment, said substrate may be an elastomeric substrate, preferably a silicone or a PDMS substrate.

In one embodiment, the method comprises a final step of disposing an encapsulating layer.

A further object of the present invention relates to an electrical conductor manufactured by performing a method according to the present invention, said electrical conductor comprising:

a biphasic conductive layer (602) with a solid metal alloy 601 as a solid phase and a liquid metal 400 as a liquid phase deposed thereon, wherein said solid metal alloy 601 is the result of the diffusion of said liquid metal 400 in a solid conductive metal film 600, wherein said conductive layer or film 600 comprises a plurality of grooves 300, and wherein said liquid metal 400 at least partially fills said grooves 300.

According to an embodiment, said electrical conductor further comprises a substrate 200 and said solid metal conductive layer or film 600 on a surface thereof, wherein said surface of said substrate 100 comprises said plurality grooves 300, and the exposed surface of said conductive layer or film 600 still comprises said plurality of grooves 300.

According to an embodiment, said grooves 300 are defined by a plurality of protrusions 200, each protrusion having a height h, a length a and a depth d, said protrusions 200 being separated by said grooves 300.

In one embodiment, said solid metal alloy may be an alloy of one of Gallium and a Gallium-based alloy, alloyed with one of Au, Pd, Pt, Ir and an alloy thereof.

In one embodiment, the thickness of said solid metal alloy layer or film may be between 1nm and 1$\mu$m, such as about 100 nm.

In one embodiment, the ratio n between the number of atoms of said liquid metal and the number of atoms of said solid metal in said biphasic layer or film may be $\geq 4$, and preferably between 4 and $10^9$, such as 100 or $10^5$.

In one embodiment, said substrate is an elastomeric substrate, preferably a silicone or a PDMS substrate.

In one embodiment, the plurality of protrusions are evenly disposed along at least a portion of the substrate.

In one embodiment, the plurality of protrusions have a small aspect ratio.

In preferred embodiments, the protrusions are shaped as regular or irregular polyhedral pillars.

In one embodiment, the electrical conductor further comprises an encapsulating layer.

Brief description of drawings

In the Figures:

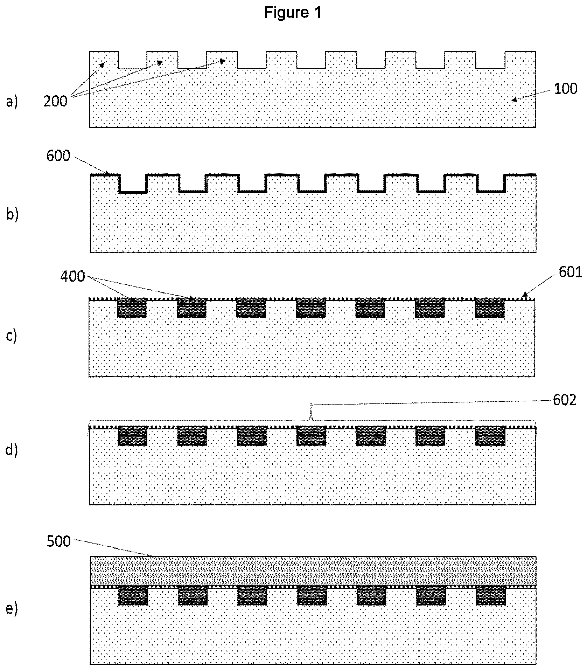

Figure 1 depicts a flow chart of one embodiment the method according to the invention: a) substrate patterning; b) deposition of a metal wetting layer on the substrate's patterned surface; c)-d) deposition of a liquid metal on the substrate and alloying; e) encapsulation;

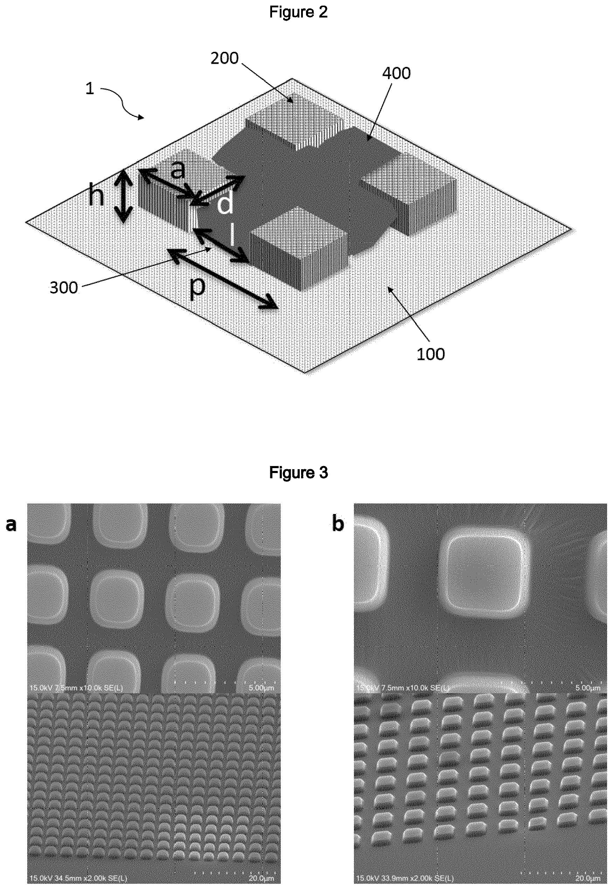

Figure 2 depicts a close-up of the structured surface of a substrate or film comprising a liquid metal deposed thereon;

Figure 3 shows a scanning electron microscopy (SEM) photography of two embodiments of the substrate or film according to the invention, in which a plurality of protrusions are evenly disposed along at least a portion of said support. The protrusions are shaped as irregular polyhedral pillars (parallelepipeds) with the same height both in a) and b) but different side and pitch between the micropillars;

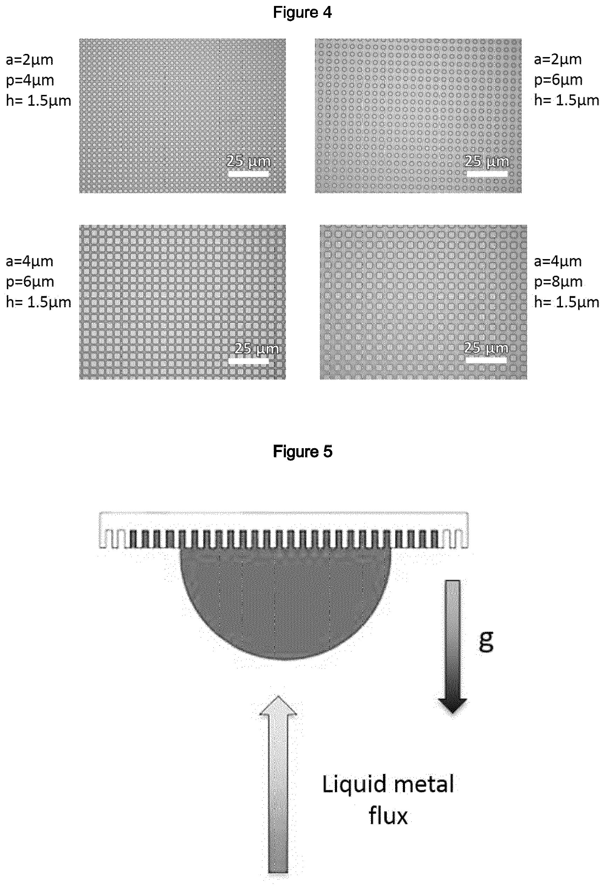

Figure 4 shows a scanning electron microscopy (SEM) photography of four embodiments of the substrate or film according to the invention, in which small aspect ratio micropillars with different dimensions have been produced;

Figure 5 shows the wetted contact condition (Wenzel mode) between a liquid metal material and a rough substrate or film as the one used according to the invention;

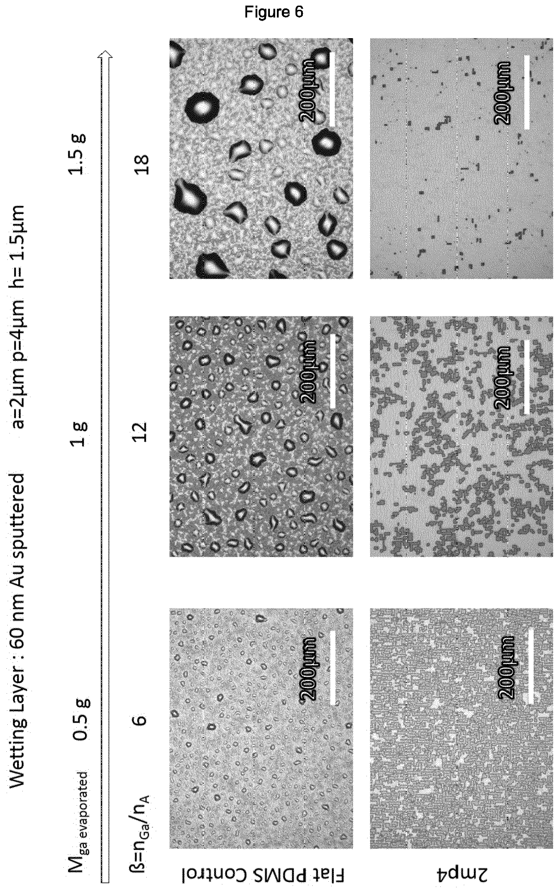

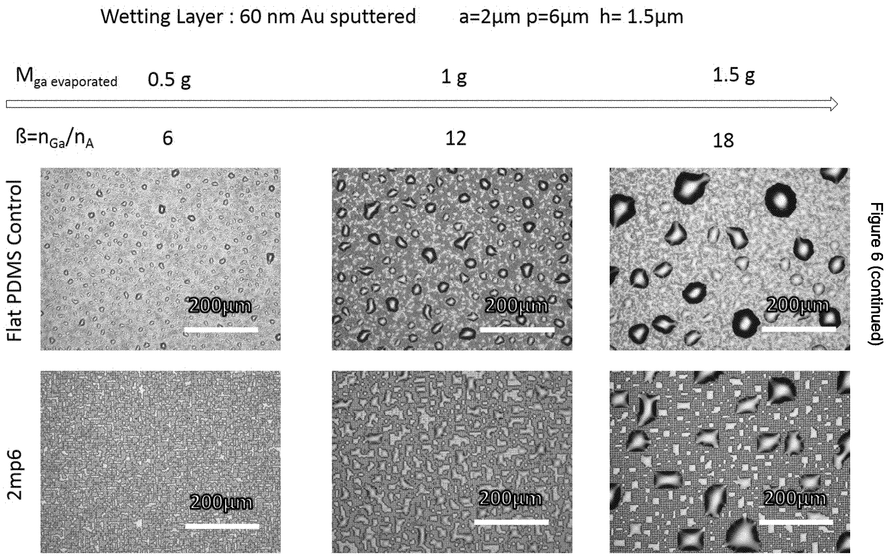

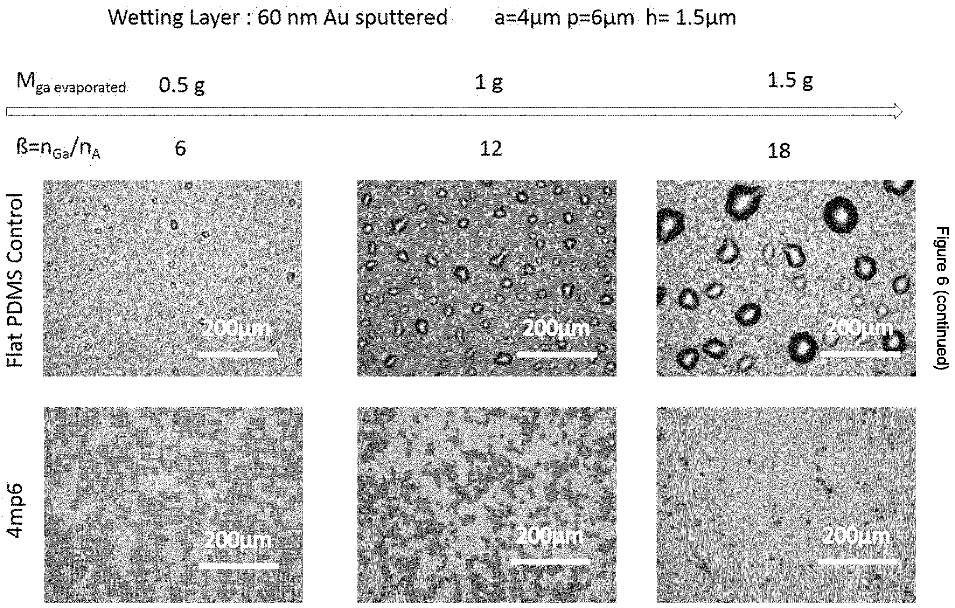

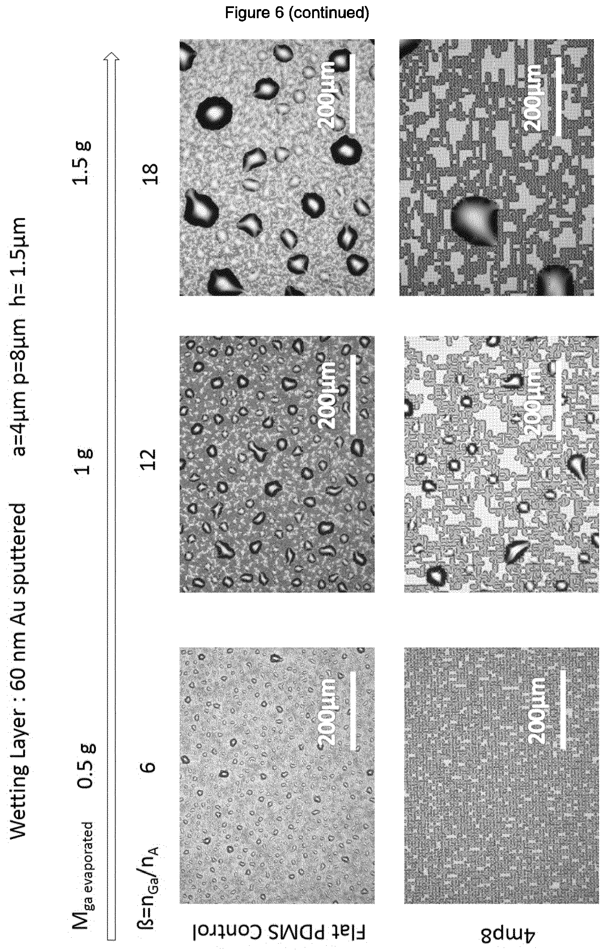

Figure 6 shows scanning electron microscopy (SEM) photographies of four biphasic electrical conductors according to the invention. The substrate has been coated with a thin film of a metal material (60 nm of gold) working as a wetting layer, and imbibed with liquid gallium. Different dimensions and pitches have been tested for the micropillars, as well as different ratios between the number of atoms of liquid gallium and the number of atoms of gold. A flat support with no protrusions has been used as a negative control;

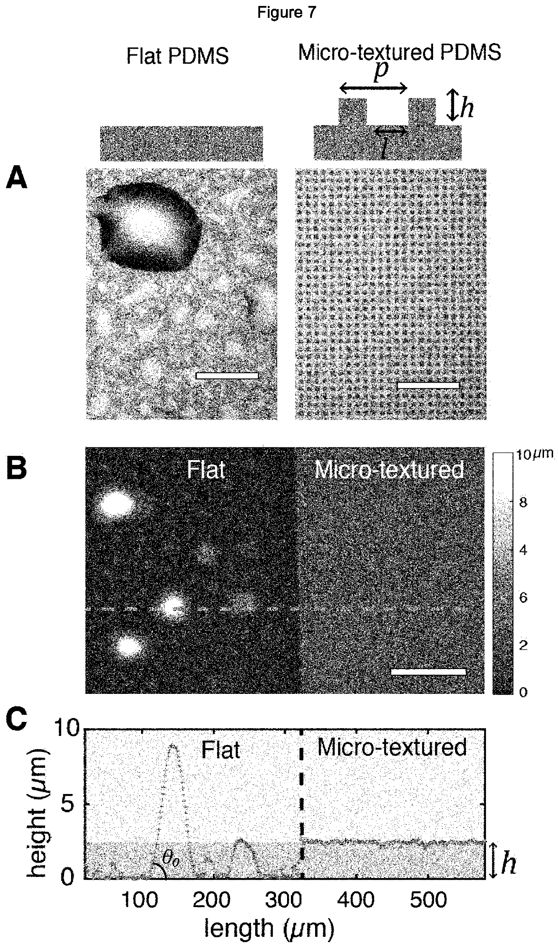

Figure 7 shows the effect of micro textured substrate on biphasic gold-gallium thin film topology: A) Microscope images of thin film as deposited on flat (left) or micro-textured (right) poly(dimethylsiloxane) (PDMS) substrate. Gallium accumulates in large bulges on flat surface resulting in a highly inhomogeneous film while the liquid metal fills the micro-texture by imbibition to form a smooth film with controlled thickness. Scale bars: 80 $\mu$m. Scale bar: 20

μm; B) Interferometric optical profilometer image of the surface of the gallium film deposited on mix flat and micro-textured PDMS substrate; C) Cross-section profile along the dotted line indicated on the interferometer image displayed in (B);

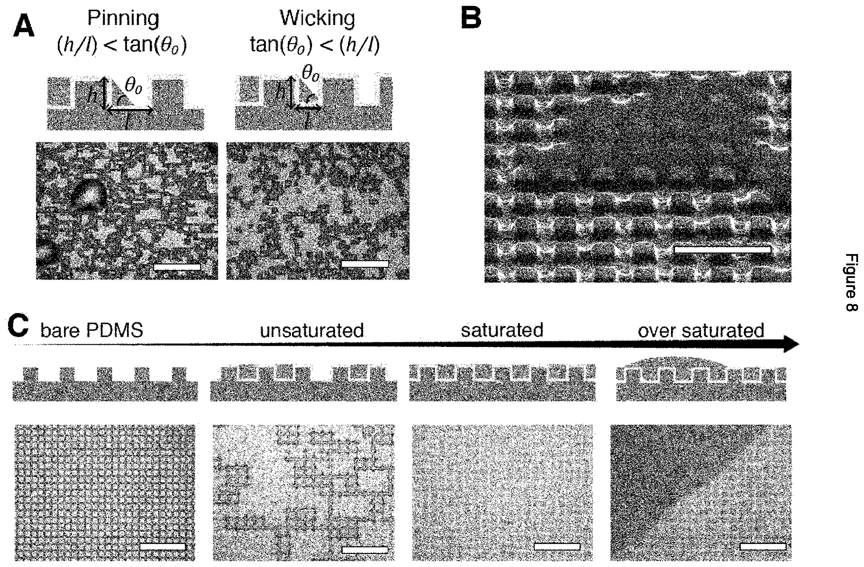

Figure 8 shows the growth of biphasic gold-gallium thin films on micro textured PDMS membranes: A) Influence of the micro-texture geometrical parameters on imbibition regime. Optical microscope images of gallium film in a "pinned" metastable state (left) and in a "wicking" state (right). Both micro-texture consist in 4 μm squared micro pillars spaced by 4 μm with a height of 1.5μm (left) or 2.5μm (right). Scale bars are 150 μm; B) SEM image of an unsaturated of micro-textured PDMS. Scale bar is 8 μm; C) Schematic representations and optical microscope images of the growth of the gallium film on micro-textured PDMS substrate. Scale bar are 30 μm;

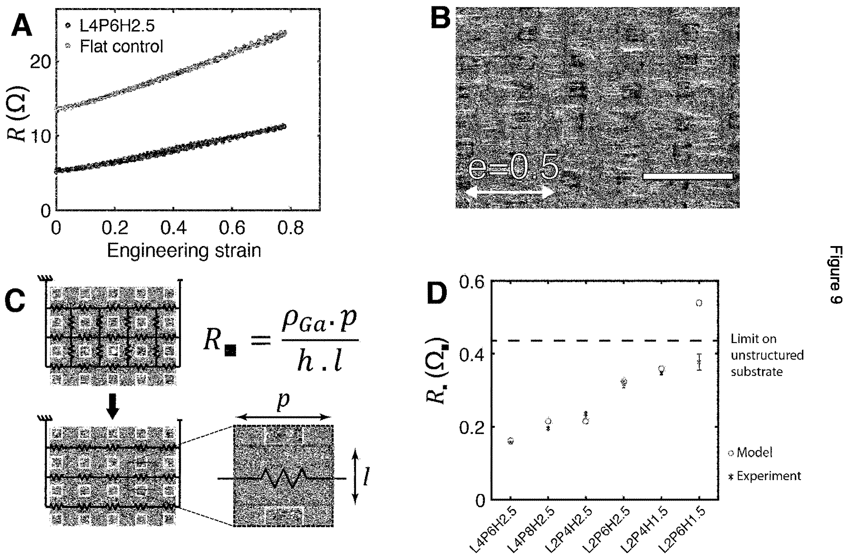

Figure 9 shows the electromechanical response of biphasic gold-gallium films on micro textured substrates under large uniaxial deformation: A) Change of electrical resistance as a function of applied engineering strain e of biphasic conductive tracks (15x0.5 mm) on micro-textured (dark dots) and flat (clear dots) PDMS substrate; B) SEM images of the surface of biphasic gold-gallium thin film on micro-textured substrate under 50% applied engineered strain; C) Equivalent electrical circuit and theoretical sheet resistance as function of geometrical parameters of the micro-texture; D) Theoretical end experimentally measured sheet resistance of biphasic film on different micro-textured substrates;

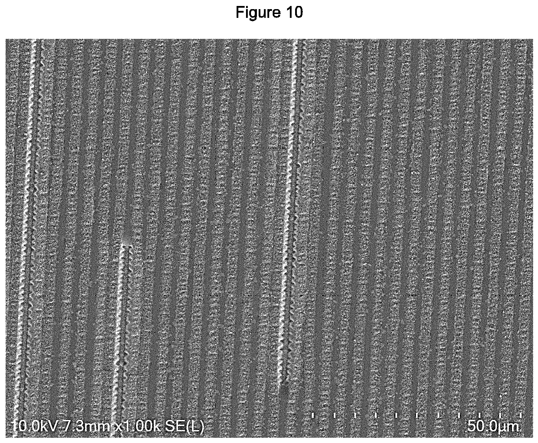

Figure 10 shows a SEM photography of one embodiment of the electrical conductor of the invention, wherein the protrusions are shaped as long stripes spanning in a parallel fashion along the substrate.

Description of embodiments

The present invention may be more readily understood by reference to the following detailed description of embodiments thereof as depicted in the drawings. It is however to be understood that the present invention is not limited to the embodiments thereof as described in the following, neither to specific conditions or parameters described and/or shown herein, and that the terminology used herein is for the purpose of describing particular embodiments by way of example only and is not intended to be limiting of the invention as claimed.

As used herein and in the appended claims, the singular forms "a", "an" and "the" include plural referents unless the context clearly dictates otherwise. Also, the use of "or" means "and/or" unless stated otherwise. Similarly, "comprise", "comprises", "comprising", "include", "includes" and "including" are interchangeable and not intended to be limiting. It is to be further understood that where descriptions of various embodiments use the term "comprising", those skilled in the art would understand that in some specific instances, an embodiment can be alternatively described using language "consisting essentially of" or "consisting of."

The embodiments of the present invention as described hereinafter represent simple an elegant solutions to tackle and overcome the prior art shortcomings. In more detail, among the possible and convenient applications of the method of the present invention, manufacturing electrical conductors, electrical conductive strips, paths, lines, arrays or the like may be mentioned. The method according to the present invention, however, revealed to be convenient as well for manufacturing electrodes or conductive paths in general, in particular for manufacturing stretchable electrical conductors, electrode arrays, paths, strips or the like. Still in more details, according to the present invention liquid and solid metals are used, in combination, for producing and/or manufacturing electrical conductors, electrode arrays, conductive circuits, paths, strips or the like, in particular bendable and/or stretchable.

As a way of example, and without limitation, Figure 1 depicts a general process flow diagram of one embodiment of the method of the present invention. During a first method step (Figure 1a), a substrate 100 is provided. Some suitable exemplary substrate materials are for instance rigid ones such as plastics, metals or glass, or flexible and/or stretchable materials such as various elastomers or foams, PDMS, PMMA, PVC or the like. In a particular embodiment, the substrate 100 is an elastomeric substrate, for instance a PDMS substrate.

The thickness of the substrate 100 may range from 1 μm to 10 cm according to the needs and/or circumstances. Still by way of non-limiting example, providing the substrate 100 may comprise spin coating a PDMS layer on a carrier (not depicted), for instance a silicon carrier (wafer or the like), curing the layer 100 at 80°C and removing the carrier.

Once the substrate 100 chosen, a plurality of protrusions 200 are disposed or preferably fabricated/patterned on at least one surface of the substrate 100. This step is considered optional when the substrate 100 is already provided in a patterned shape. For instance, in one embodiment the protrusion 200 are made by lithography, molding, printing or etching of the substrate 100. Preferably, the plurality of protrusions 200 are evenly disposed along at least the portion of the substrate 100, and in particular embodiments the protrusions 200 are shaped as regular or irregular polyhedral pillars. Additionally or alternatively, the protrusions 200 can be shaped as long stripes arranged on the support 100 in any suitable direction, wherein said stripes have a length which is substantially higher in size compared to the other dimensions, such as of one or several orders of magnitude (Figure 10). This arrangements of the protrusions 200 can be advantageously used or exploited for certain applications, such as for the creation of anisotropic sensors.

The protrusions have a height h, a length a and a depth d, and are separated by void interspaces hereinafter referred to as grooves l (300). A pitch p defines the interspace between the same point of two adjacent protrusions 200 (Figure 2). The protrusions 200 can be integral portions of the substrate 100 stemming directly from the surface of this latter, or can be integrated on the substrate 100 by e.g. adhesives. In a preferred embodiment according to the invention, substrate 100 is shaped to include on a surface thereof protrusions 200, which are therefore made of the same material. For instance, the substrate 100 can be molded as a unitary, integral body of plastic from any suitable standard polymer material known in the art (e.g., polystyrene, polypropylene, polycarbonates, polysulfones, polyesters, cyclic olefins and so forth) using well-known injection molding methods. Soft polymers and elastomers such as polydimethylsiloxane (PDMS), acrylic elastomer, rubber, polyurethane (PU), polyvinylidene fluoride (PVDF) or combinations thereof are also suitable and, in certain embodiments, preferably used materials.

Preferably, the plurality of pillar protrusions 200 have a small aspect ratio (Figures 3 and 4). As used herein, "aspect ratio" has the meaning of the ratio between the height and the lateral feature size. This aspect of the invention is tightly linked, as will be detailed later on, to the behaviour of the liquid metal 400 at the moment of its deposition on the substrate 100. Accordingly, in the frame of the present disclosure, a "small aspect ratio" is intended that the ratio between the height h and the lateral sizes a or d of each protrusion 200 is preferably comprised between 0.1 and 10, such as for instance 2.5, 1.5, 1.25, 0.75, 0.625 or 0.375. In some preferred embodiments, the length a and the depth d of the protrusions 200 are equal, which is typically the case of some parallelepiped, cubic, polygonal or cylindrical pillars, and can be measured at the basis or at the top of said pillars.

Within the frame of the present invention, other parameters have been investigated related to the protrusions' 200 dimensions; in particular, the ratio between the height h and the grooves' length l is preferably comprised between 0.1 and 10, such as for instance 2.5, 1.5, 1.25, 0.75, 0.625 or 0.375. The dimensions h, a, d and g of the pillars 200 can usually span from 0.5 to 100 $\mu$m (Figure 4).

This combination of solutions is particularly advantageous at the moment of the liquid metal 400 deposition, which in preferred embodiments according to the invention is gallium or a gallium-based alloy.

During a second step, as depicted in Figure 1b, the substrate 100 is coated with a thin film 600 of a solid conductive metal. This step is considered optional when the patterned substrate 100 is already provided with a metal coating.

The thin film 600 of a solid conductive metal, deposited on the substrate 100 and the protrusions 200, acts as a wetting layer facilitating the deposition and the adhesion of the liquid metal 400 within the grooves 300 between the protrusions 200, that in one embodiment is performed along the entire substrate 100. By way of example, the film 600 may be provided on the substrate 100 by deposing a metal such as Au, Pd, Pt, Ir or alloys thereof via physical vapour deposition, chemical vapour deposition, spray, condensation or sputtering on the substrate 100. As a way of example, the wetting layer thin film can have a thickness comprised between 1 nm and 1 $\mu$m, such as about 50 nm. Still by way of example, a gold film 600 can be sputtered, the final thickness thereof being for instance around 60 nm. In an implemented embodiment, the addition of a thin wetting layer of gold 600 of around 60 nm in thickness facilitates the deposition of liquid gallium 400 on a PDMS substrate 100.

During a third step as depicted in Figure 1c, one or more liquid metals 400 are deposited on the film 600 by e.g. physical vapour deposition, chemical vapour deposition, spray, condensation. During the third step, the liquid metal (for instance gallium) diffuses into the solid film 600 and alloys with the solid film to form an alloy 601 (for instance AuGa2 in case Au is used for forming the solid conductive layer 600 and Ga is used as a liquid metal 400). As to the liquid metals, gallium and a gallium-based alloy may be used according to the present invention; however, gallium has revealed to provide the best results since the stoichiometry of the evaporated film is the same as the stoichiometry of the original material. Moreover, as to the deposition of the liquid metal, thermal evaporation of one or both of the above mentioned gallium and a gallium-based alloy has revealed to be the most preferred solution.

The situation at the end of the third step is therefore that depicted in Figure 1d, namely with a biphasic conductive film or layer 602 comprising both a solid phase (the alloy) 601 and a liquid phase 400.

In the frame of the present invention, several technical procedural parameters have been investigated; it has therefore been assessed by the inventors that the atomic ratio nGa/nAu (i.e. the ratio between the number of gallium atoms - liquid metal 400- and the number of Gold atoms in the wetting layer -metal layer 600-) offering the best results in terms of formation of an homogeneous biphasic conductive layer is nGa/nAu $\geq$ 4, and preferably a nGa/nAu comprised between 4 and $10^9$, such as for instance 100 or $10^5$.

After an extensive design optimization and rationalization made by the inventors on the conductors of the invention obtainable through the present method, concerning the ratio between the height h and the lateral sizes a or d of each protrusion 200 of the substrate 100, it has been assessed that small aspect ratio pillars having a h/a ratio comprised between 0.1 and 10 , such as for instance 2.5, 1.5, 1.25, 0.75, 0.625 or 0.375, and a h/g ratio the ratio comprised between 0.1 and 10, such as for instance 2.5, 1.5, 1.25, 0.75, 0.625 or 0.375, favour the imbibition of a microtextured substrate 100 carried out by a liquid metal 400 so that this latter can uniformly and homogeneously distribute along the support 100.

According to a non-limiting example, for parallelepiped micropillars 200 having a=d and dimensions h, a, d and g comprised between 0.5 to 100 $\mu$m, such ratio values make the microtextured substrate 100 compatible with the homogeneous wetting regime of a roughened surface wetted by a droplet described by the Wenzel model. In this scenario, gravity and hydrostatic pressure can be neglected if the drops are smaller than the capillary length (i.e., for micrometric drops of liquid metal 400), whereas capillary forces and Laplace pressure apply (Figure 5). A critical contact angle between the micropillars 200 and a liquid or liquefied metal 400 disposed thereon and spreading within the grooves 300, said contact angle being determined by the micropillars' 200 dimensions and distance, defines a threshold for imbibition so that a filling material drop is not pinned in a metastable situation but can propagate.

According to some implemented embodiments, a PDMS elastomeric substrate 100 has been patterned by molding with a plurality of evenly disposed squared (cubic or parallelepiped) micropillars 200 typically of 1$\mu$m to 4$\mu$m in side (a and/or d) and 1 $\mu$m to 2.5 $\mu$m in height (h). In particular, h was 1.5 or 2.5 $\mu$m, a=d was 1, 2 or 4 $\mu$m and p was 2, 4, 6 or 8 $\mu$m (Figure 6). A thin film (60 nm) of a gold wetting layer 600 has been sputtered on the substrate 100 and micropillars 200 so to coat the entire structure. Subsequently, liquid gallium 400 has been thermally evaporated by physical vapour deposition on the gold-coated patterned structure in a saturating condition. As used herein, a "saturating condition" refers to a process setup by which the amount of the liquid metal used for adsorption or otherwise adhesion on a substrate is such that all the grooves 300 present on the substrate 100 are covered or imbibed by the liquid metal 400 without the presence of bulges of liquid metal 400. Since the saturation corresponds to the point when the whole volume in between pillars 200 are filled with liquid metal 400, a person skilled in the art would easily extrapolate and calculate for each set geometry of pillars this volume.

The above example has been solely used to describe and illustrate more clearly the present invention, which however is not intended to be limiting of the same. In particular, although the method as disclosed above comprises the provision of the substrate 100, the provision of the protrusions 200 (and corresponding grooves) on the surface of the substrate, and the provision of the metal film 600 on the patterned surface of the substrate 100, within the scope of the present invention the substrate 100 is not essential and can be omitted, accordingly. Omitting the substrate 100 means that the protrusions 200 (and corresponding grooves) may be formed (by any of the above mentioned solutions) directly on the metal film 600.

In one embodiment of the invention, the method comprises an optional last step of disposing an encapsulating layer 500 above the protrusions 200 and the biphasic conductive layer (Figure 1e). Encapsulation can be performed by methods known in the art; the material composing the encapsulation layer 500 can comprise or consist of materials such as glass or preferably polymeric materials such as plastics (e.g., polystyrene, polypropylene, polycarbonates, polysulfones, polyesters, cyclic olefins and so forth). Alternatively, soft polymeric materials such as elastomers, rubber, polyurethane (PU), polyvinylidene fluoride (PVDF) or combinations thereof, can be disposed e.g. by lamination, pouring, evaporation, chemical vapour deposition, physical vapour deposition or spraying and possibly cured, whenever needed. Preferred encapsulating materials for the layer 500 are polydimethylsiloxane (PDMS), poly(p-xylylene) polymers such as Parylene or epoxy resins.

Still according to an embodiment of the present invention and depending on the needs and/or circumstances, during a further optional step not depicted in the drawings, one or more through vias can be formed in the upper encapsulation layer 500 so as to expose one or more portions of the conductive biphasic film or array 602, wherein the exposed portions can be used for instance as contacting pads for electrical connection of the film, for instance wiring connection or stacking and connecting multiple metallized layers. The above mentioned patterning and/or encapsulation and/or wiring steps are not disclosed in detail for the sake of conciseness.

As it will be evident, the present invention further relates to an electrical conductor (eventually manufactured by performing a method according to the present invention), said electrical conductor comprising:

a substrate 100 comprising a surface having a plurality of protrusions 200, each protrusion having a height h, a length a and a depth d,, said protrusions 200 being separated by grooves 300; and a conductive layer or film on said substrate, said conductive layer or film being a biphasic conductive layer 602 with a solid metal alloy 601 as a solid phase and a liquid metal 400 as a liquid phase deposited thereon and between the grooves 300.

Generally speaking, electrical conductors according to the invention are typically flat, thin stripes or films characterized by a patterned profile of a surface thereof, said surface including the biphasic conductive layer 602 as described. The thickness of the substrate 100 may range from 1 $\mu$m to 10 cm according to the needs and/or circumstances. Nonetheless, the electrical conductors of the invention could have a non-flat shape, and/or can include a patterned profile of the substrate 100 on more than one surface, said surfaces having a biphasic conductive layer 602 deposed thereon. In one embodiment, said solid metal alloy 601 may be an alloy of one of gallium and a gallium-based alloy, alloyed with a solid metal layer or film of Au, Pd, Pt, Ir and an alloy thereof.

In one embodiment, the thickness of said solid metal alloy layer or film 601 may be between 1nm and 1$\mu$m, such as about 100 nm. In one embodiment, the ratio n between the number of atoms of said liquid metal 400 and the number of atoms of said solid metal 601 in said biphasic layer or film may be ≥ 4, and preferably

between 4 and 10$^9$, such as for instance 100 or 10$^5$.

In one embodiment, said substrate 100 (if provided) is an elastomeric substrate, preferably a silicone or a PDMS substrate.

In one embodiment, the plurality of protrusions 200 are evenly disposed along at least a portion of the substrate 100.

In one embodiment, the plurality of protrusions 200 have a small aspect ratio. In particular embodiments, the protrusions 200 are shaped as regular or irregular polyhedral pillars. In particular, the ratio between the height h and the lateral sizes a or d of each protrusion 200 is preferably comprised between 0.1 and 10, such as for instance 2.5, 1.5, 1.25, 0.75, 0.625 or 0.375. In some preferred embodiments, the length a and the depth d of the protrusions 200 are equal, which is typically the case of some parallelepiped, cubic, polygonal or cylindrical pillars, and can be measured at the basis or at the top of said pillars. Preferably, the ratio between the height h and the grooves' length l is preferably comprised between 0.1 and 10, such as for instance 2.5, 1.5, 1.25, 0.75, 0.625 or 0.375. The dimensions h, a, d and g of the pillars 200 can usually span from 0.5 to 100 $\mu$m. The protrusions 200 can be arranged in any suitable kind of array or pattern, such as square or triangular/hexagonal pattern. Moreover, for the sake of clarity, in some embodiments the protrusions 200 are shaped as round or rounded pillars, arranged for instance in a square or triangular/hexagonal pattern.

In embodiments where substrate 100 is an elastomeric substrate, stretchable biphasic electrical conductors can be produced by the methods according to the invention. Stretchable biphasic electrical conductors of the invention can be elastically stretched by up to about 500%, 100%, 50% and retain electrical conductivity. In this context, stretchable biphasic electrical conductors according to the invention have been shown to have excellent performance in terms of electromechanical properties such as sheet resistance and gauge factor, particularly compared with a non-patterned, flat stretchable biphasic electrical conductor. Sheet resistance is lower compared to a non-textured counterpart since the biphasic film 602 is more homogenous, thus avoiding current concentration compared to biphasic electrical conductors comprising liquid metal bulges. In many embodiments, the sheet resistance of (stretchable) biphasic electrical conductors according to the invention can be comprised between 1 and 0.001 $\Omega$/sq.

In one embodiment, the electrical conductor further comprises an encapsulating layer 500. Stack of conductors could also be envisaged, possibly separated one from the other by encapsulating layers 500 having in certain embodiments through vias for establishing an electrical connection.

Example

PDMS substrate decorated with an array of square micro-pillars were prepared by soft lithography and further coated by 60 nm of gold by sputtering. Provided a wise choice of the micro-pillars dimensions, imbibition of the micro-structure by the condensing gallium is thermodynamically more favourable than the formation of drops. Thermal evaporation of gallium on such engineered substrate leads to the formation of a smooth film of gallium with controlled thickness set by the height of the micro-pillars (Figure 7a). The root mean square roughness ($R_q$) of the obtained film was assessed using an interferometric profilometer. Figure 7b and c shows the measured topology after gallium evaporation on a partially micro-structured substrate. The left side is unstructured whereas the right side of the substrate features micro-pillars with a height (h) of 2.5 $\mu$m, an inter-pillar distance (g) of 4 $\mu$m and a pitch (p) of 8 $\mu$m. On the unstructured substrate, the gallium forms an inhomogeneous film ($R_q$ = 1.6). The majority of the liquid gallium accumulates in drops displaying an averaged contact angle $\theta_0$ of 23° (std $\pm$ 3). Contrastively on the structured substrate the gallium accumulates in between the pillars up to their extremity (h = 2.5 $\mu$m) forming a smooth film ($R_q$ = 84 nm). The projected surface area of the gallium can be calculated from the pillar's geometrical features:

$$A = \frac{(2pl - l^2)}{p^2}$$

In this particular case, liquid gallium occupies 75% of the area while the rest corresponds to the pillars. Increasing the inter-pillar distance and pitch enables to maximise gallium's projected area but eventually leads to dewetting of the film.

To assess the suitable micro-structure for the formation of a smooth film, different substrates by varying the height of the pillars (h), the inter-pillar distance (l) and the pitch of the pattern (p) were prepared. It was observed that depending on the aspect ratio of the pillar (h/l) and the wetting properties on a unstructured substrate ($\theta_0$), the condensation of evaporated gallium on the superlyophilic substrate can either lead to a smooth film by imbibition of the pattern when $\tan(\theta_0)<(h/l)$ or dewetting and formation of drops when $\tan(\theta_0)>(h/l)$ (Figure 8). An

aspect ratio $\dfrac{h}{l}$ close to 0.42 enable to maximize the pojected surface covered by gallium.

Further, the growth of the gallium film when the imbibition criteria is verified was characterized (Figure 8c). Only a finite amount of liquid gallium can accumulate within the grooves of the substrate. The pattern is considered saturated when gallium occupies the whole volume in between the pillars. Under the saturation point, the dispersion of gallium is not homogenous. By capillarity, the liquid gallium rearrange to form a stochastic dispersion of coalesced gallium clusters. Increasing the amount of gallium up to point of saturation results in a smooth film. Above the saturation point the excess liquid metal aggregates in large macroscopic drops (bulges) sitting on top of the saturated substrate.

Next, it was evaluated the electromechanical performance of the obtained saturated films during uniaxial stretching cycles with resistance measurements and scanning electron microscopy (SEM). Test tracks (15x0.5mm) were uniaxially stretched (0-0.8 strain) while measuring the resistance with a 4 point set up. The gallium film on the textured substrates displayed significantly lower resistance compared to the untextured control while maintaining similar stretchability (Figure 9a). Figure 9b shows a SEM image of a gallium film on textured substrate under 50% of applied engineered strain. The liquid gallium follows the deformation and maintains a continuous and homogenous film while the distance between pillars changes as the substrate deforms.

The electrical resistance of the saturated film was then modelled by a network of resistors as depicted in Figure 9c. Due to the symmetry of the system, every node sharing the same abscissa along the main axis have the same potential. As a result, the resistors perpendicular to the main axes can be neglected. The theoretical sheet resistance of the film at the relaxed state then corresponds to the resistance of a unit resistor from the grid and is given by the following equation:

$$R_\square = \frac{\rho_{Ga} \cdot p}{h \cdot l},$$

where $\rho_{Ga}$ is the electrical conductivity of gallium and $p$, $h$, $l$ the geometrical parameters of the pillars array. Consequently the sheet resistance of the film can be tailored to a specific value by choosing the right geometrical parameters. The obtained model was confronted to experimental measurement of the sheet resistance (n=3 per condition) with 6 different micro-pillars design as depicted in Figure 9d. The model showed a good match with the experimental measurements except for one sample at the limit of resolution of the lithography.

In addition to a lower sheet resistance, the homogenous film obtained on the structured substrate also provides a better distribution of the current in the conductor.

*Textured Mould preparation:*

4 in. silicon wafers were exposed to Bis(trimethylsilyl)amine (HMDS) and spin-coated to form 2 to 5 $\mu$m thick photoresist film (AZ-1512 from MicroChemicals) and then cured at 100°C for 60s. The resist was then exposed with 180 mJ cm-2 dose (MLA maskless aligner Heideleberg), developed in diluted AZ-400-K and dried. The wafer was then exposed to a short plasma and treated with a self-assembled layer of trichloro(1H,1H,2H,2H-perfluorooctyl) silane (Sygma Aldrich) in a dessicator.

*Gallium super-lyophilic PDMS substrate preparation:*

Poly(dimethylsiloxane) (PDMS) (Sylgard 184, Dow Corning, mixed at 10:1 (w:w), prepolymer:crosslinker) was spin-coated on a micro-textured mould (500 RPM for 1 min) and cured at 80 °C for at least 2 h in a convection oven. The PDMS layer was then pilled-off from the mould and manually transferred, with textured surface facing up, to a 4 in. carrier wafer. A customized Kapton shadow mask patterned with desired layout was aligned and laminated on the micro-textured PDMS substrate. Then, 60 nm of gold was sputtered through the shadow mask (AC 450, Alliance Concept).

*Gallium Evaporation:*

A mass of pure gallium ranging from 0.5 to 2 g was thermally evaporated (E300, Alliance Concept) on the gallium super-lyophilic substrate. After evaporation, the Kapton mask was delicately peeled off the substrate to form the desired pattern.

*Interferometric Profilometer:*

Interferometric profilometer data were acquired unsing a ContourGt profilometer from Bruker an OLS 4100 from Olympus and further analysed with Vision 64 software and custom matlab code.

*Scanning Electron Microscopy:*

SEM images were acquired in a SU5000 microscope from Hitachi, using the secondary electron detector at a beam energy of 5 keV.

*Test samples preparation:*

Gallium conductors were stencil-patterned on 120 $\mu$m super-lyophilic PDMS substrate to produce 15 mm long and 0.5 mm wide electrical conductors. Samples were subsequently cut in 10 mm by 30 mm rectangles and peeled from the wafer.

*Uniaxial Electromechanical Characterization:*

Test samples were mounted on a custom-built uniaxial tensile stretcher programmed to actuate two clamps moving in opposite directions along the horizontal plane. Each clamp featured two contact pads that provided constant electrical and mechanical contact to the sample under test. The position of the clamps and the electrical resistance of the conductor, measured using a four-point probe method (2400 source-meter, Keithley), were acquired synchronously at 3.8 Hz on a computer running a dedicated LabVIEW program.

*Thermal Test:*

Test samples were clamped in the uniaxial stretcher. Electrical resistance and current running through of the conductor were measured using a 4-point probes method (2400 source-meter, Keithley) and acquired synchronously at 3.8 Hz on a computer running a custom LabVIEW program (Fig. S8). In parallel, a thermal camera (A325 sc, FLIR systems) and close up lens (1x 25 $\mu$m, FLIR systems) were used to monitor synchronously the temperature at the surface of the samples (sampling rate: 60Hz).

**Claims**

1. A method for manufacturing an electrical conductor, said method comprising:

   a) providing a a solid metal conductive layer or film (600);
   b) depositing a liquid metal (400) on said solid layer (600);
   c) allowing said liquid metal (400) and said solid layer (600) to alloy by diffusion of said liquid metal (400) into said solid layer or film (600) so as to form a solid conductive layer or film (601) of said alloy; and
   d) allowing said liquid metal (400) to further depose onto said alloy layer (601) so as to form a biphasic conductive layer (602) comprising said solid layer or film (601) as a solid phase and said liquid metal (400) as a liquid phase deposed thereon,

   **characterized in that** said surface of said conductive layer or film (600) comprises a plurality of grooves (300), and **in that** said liquid metal (400) is allowed to further depose onto said solid layer or film (601) so as to at least partially fill said grooves (300).

2. A method according to claim 1, **characterized in that** said method comprises:

   providing a substrate (200);
   providing a solid metal conductive layer or film (600) on a surface thereof;
   wherein said surface of said substrate (200) comprises said plurality grooves (300), and wherein providing said solid metal conductive layer or film (600) on said surface of said substrate (200) is carried out so that the exposed surface of said conductive layer or film (600) still comprises said plurality of grooves (300).

3. A method according to one of claims 1 and 2, **characterized in that** said grooves (300) are defined by a plurality of protrusions (200), each protrusion having a height h, a length a and a depth d, said protrusions (200) being separated by said grooves (300).

4. The method of claim 3, **characterized in that** the protrusions (200) are shaped as regular or irregular polyhedral pillars.

5. The method of any previous claim, **characterized in that** said liquid metal (400) is deposited on said solid conductive metal layer or film (600) by physical vapour deposition, chemical vapour deposition, spray or condensation of said liquid metal (400).

6. The method of any previous claim, **characterized in that** said liquid metal (400) comprises one of gallium and a gallium-based alloy.

7. The method of any previous claim 2 to 6, **characterized in that** said solid metal conductive layer or film (600) is sputtered on said substrate (100).

8. The method of any previous claim , **characterized in that** said solid conductive metal layer or film (600) is made of one of Au, Pd, Pt, Ir, and an alloy thereof.
   The method of any previous claim, **characterized in that** the thickness of said solid layer or film (600) is between 1 nm and 1$\mu$m, such as about 50 nm.

9. The method of any previous claim, **characterized in that** the ratio n between the number of atoms of said liquid metal (400) and the number of atoms of said solid metal (600) in said biphasic layer or film (602) is $\geq$ 4, and preferably between 4 and $10^9$, such as 100 or $10^5$.

10. The method of any previous claim 2 to 9, **characterized in that** said substrate (100) is an elastomeric substrate, preferably a silicone or a PDMS substrate.

11. The method of any previous claim, **characterized in that** the method comprises a final step of disposing an encapsulating layer (500).

12. An electrical conductor manufactured by performing a method according to claims 1 to 11, said electrical conductor comprising:

   - a biphasic conductive layer (602) with a solid metal alloy (601) as a solid phase and a liquid metal (400) as a liquid phase deposed thereon, wherein said solid metal alloy (601) is the result of the diffusion of said liquid metal (400) in a solid conductive metal film (600), wherein said conductive layer or film (600) comprises a plurality of grooves (300), and wherein said liquid metal (400) at least partially fills said grooves (300).

**13.** An electrical conductor according to claim 12, further comprising a substrate (200) and said solid metal conductive layer or film (600) on a surface thereof, wherein said surface of said substrate (100) comprises said plurality grooves (300), and the exposed surface of said conductive layer or film (600) still comprises said plurality of grooves (300).

**14.** An electrical conductor according to claim 12 or 13, wherein said grooves (300) are defined by a plurality of protrusions (200), each protrusion having a height h, a length a and a depth d, said protrusions (200) being separated by said grooves (300).

**15.** The electrical conductor of one of claims 12 to 14, wherein said solid metal alloy (601) is an alloy of one of gallium and a gallium-based alloy, alloyed with one of Au, Pd, Pt, Ir and an alloy thereof.

**16.** The electrical conductor of claims 12 or 13, wherein the thickness of said solid metal alloy layer or film (601) is between 1nm and $1\mu m$, such as about 100 nm.

**17.** The electrical conductor of one of claims 12 to 16, **characterized in that** the ratio n between the number of atoms of said liquid metal (400) and the number of atoms of said solid metal (601) in said biphasic layer or film (602) is $\geq 4$, and preferably between 4 and $10^9$, such as 100 or $10^5$.

**18.** The electrical conductor of claims 13 to 17, **characterized in that** said substrate (100) is an elastomeric substrate, preferably a silicone or a PDMS substrate.

**19.** The electrical conductor of claims 14 to 18, **characterized in that** the plurality of protrusions (200) are evenly disposed along at least a portion of the substrate (100).

**20.** The electrical conductor of claims 14 to 19, **characterized in that** the protrusions (200) have a small aspect ratio.

**21.** The electrical conductor of claims 14 to 20, **characterized in that** the protrusions (200) are shaped as regular or irregular polyhedral pillars.

**22.** The electrical conductor of claims 12 to 21, **characterized in that** the electrical conductor further comprises an encapsulating layer (500).

Figure 1

a)

200 — 100

b)

600

c)

400 — 601

d)

602

e)

500

Figure 2

Figure 3

## Figure 4

a=2µm
p=4µm
h= 1.5µm

25 µm

a=2µm
p=6µm
h= 1.5µm

25 µm

a=4µm
p=6µm
h= 1.5µm

25 µm

a=4µm
p=8µm
h= 1.5µm

25 µm

## Figure 5

g

Liquid metal
flux

Figure 6

Figure 6 (continued)

Figure 6 (continued)

Wetting Layer : 60 nm Au sputtered     a=4μm p=8μm  h= 1.5μm

$M_{ga\ evaporated}$     0.5 g          1 g          1.5 g

$\beta = n_{Ga}/n_A$     6          12          18

Flat PDMS Control

4mp8

Figure 6 (continued)

Figure 7

Figure 8

Figure 9

Figure 10

10.0kV 7.3mm x1.00k SE(L)    50.0µm

Europäisches
Patentamt

European
Patent Office

Office européen
des brevets

# EUROPEAN SEARCH REPORT

Application Number

EP 18 19 5348

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HYUN-JOONG KIM ET AL: "A Biaxial Stretchable Interconnect With Liquid-Alloy-Covered Joints on Elastomeric Substrate", JOURNAL OF MICROELECTROMECHANICAL SYSTEMS, IEEE SERVICE CENTER, US, vol. 18, no. 1, 4 February 2009 (2009-02-04), pages 138-146, XP011241585, ISSN: 1057-7157, DOI: 10.1109/JMEMS.2008.2011118 * page 142, left-hand column, last paragraph; figures 7,13 * * page 143, left-hand column, paragraph F * | 1-22 | INV.<br>H01B1/02<br>C22C1/00<br>H05K1/02 |
| A | ----- <br>HADRIEN O MICHAUD ET AL: "Soft metal constructs for large strain sensor membrane", SMART MATERIALS AND STRUCTURES, IOP PUBLISHING LTD., BRISTOL, GB, vol. 24, no. 3, 10 February 2015 (2015-02-10), page 35020, XP020280746, ISSN: 0964-1726, DOI: 10.1088/0964-1726/24/3/035020 [retrieved on 2015-02-10] * 2. Results; figures 6,7 * * page 7, left-hand column, paragraph 2 * <br>----- | 1-22 | TECHNICAL FIELDS SEARCHED (IPC)<br><br>H01B<br>C22C<br>H05K |

-/--

The present search report has been drawn up for all claims

| Place of search | Date of completion of the search | Examiner |
|---|---|---|
| The Hague | 18 January 2019 | Baldé, Kaisa |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 18 19 5348

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BONGSOO KIM ET AL: "Interfacing Liquid Metals with Stretchable Metal Conductors", ACS APPLIED MATERIALS & INTERFACES, vol. 7, no. 15, 22 April 2015 (2015-04-22), pages 7920-7926, XP055267456, US ISSN: 1944-8244, DOI: 10.1021/am508899z * page 7922, left-hand column, paragraph 2 - right-hand column, paragraph 2; figure 4 * | 1-22 | |
| | ----- | | |
| A | ARTHUR HIRSCH ET AL: "Intrinsically Stretchable Biphasic (Solid-Liquid) Thin Metal Films", ADVANCED MATERIALS, vol. 28, no. 22, 29 February 2016 (2016-02-29), pages 4507-4512, XP55407964, DE ISSN: 0935-9648, DOI: 10.1002/adma.201506234 * page 4507, last paragraph - page 4508 * * page 4509, right-hand column; figure 2 * | 1-22 | |
| | ----- | | TECHNICAL FIELDS SEARCHED (IPC) |

The present search report has been drawn up for all claims

| Place of search | Date of completion of the search | Examiner |
|---|---|---|
| The Hague | 18 January 2019 | Baldé, Kaisa |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2017072347 A

**Non-patent literature cited in the description**

- **COURBIN et al.** *Nature Materials,* 2007, vol. 6, 661-664
- **HIRSCH et al.** *Adv. Mater.,* 2016, vol. 28, 4507-4512